# DEMANDE DE BREVET EUROPEEN

(11) **EP 3 026 992 A1**
(43) Date de publication de la demande: **01.06.2016**
(21) Numéro de dépôt: 15195646.3
(22) Date de dépôt: 20.11.2015
(51) Int. Cl.: H05K 9/00, H01F 27/36

(54) **BLINDAGE MAGNÉTIQUE AMÉLIORÉ**

(30) Priorité: 28.11.2014 FR 1461625
(71) Demandeur: Commissariat à l'Energie Atomique et aux Energies Alternatives, 75015 Paris (FR)
(72) Inventeur: Le Prado, Matthieu, 38160 Saint-Marcellin (FR); Morales, Sophie, 38760 Varces (FR); Corsi, Marie-Constance, 13200 Arles (FR); Viana, Antonio, 38320 Herbeys (FR)
(74) Mandataire: Talbot, Alexandre

(57) **Abrégé**

L'invention concerne un blindage magnétique comportant au moins une paroi latérale définissant une cavité pour contenir un objet à isoler magnétiquement. La paroi latérale comporte entre trois et cinq couches de matériau métallique ferromagnétique, et entre trois et cinq couches de matériau polymère comprenant une poudre ferromagnétique. Deux couches métalliques adjacentes sont séparées par une couche de matériau polymère.

## Description

### Domaine technique de l'invention

L'invention est relative à un dispositif de blindage magnétique dont la résistance aux chocs est améliorée.

### État de la technique

Un blindage magnétique est une enveloppe conductrice qui sépare l'espace en deux espaces devant être isolés magnétiquement l'un de l'autre. Le but d'un blindage magnétique est double, il sert à la fois à contenir les champs magnétiques à l'intérieur de l'enceinte blindée, et à empêcher l'introduction à l'intérieur de l'enceinte de champs magnétiques externes.

Pour cela, le matériau utilisé pour réaliser le blindage magnétique doit pouvoir attirer, concentrer et dévier les lignes de champs magnétiques pour empêcher leur passage dans un volume donné. Les blindages magnétiques sont réalisés à l'aide de matériaux ferromagnétiques ayant une susceptibilité magnétique élevée et un champ coercitif faible. Ils ont une perméabilité magnétique relative élevée et peuvent par exemple être du fer doux ou du permalloy. Par perméabilité magnétique relative élevée, on entend *µ*ᵣ > 1000.

La qualité d'un blindage magnétique est essentielle dans le domaine de la magnéto-cardiographie, c'est-à-dire l'étude de l'activité électrique des cellules du myocarde. Pour réaliser des mesures correctes et fiables, il est primordial que la personne qui est sujette à l'examen médical soit isolée de tout champ magnétique extérieur pouvant perturber les mesures effectuées. Or sous l'effet d'un choc mécanique ou thermique, les domaines magnétiques du matériau utilisé pour réaliser le blindage peuvent être dégradés, et il en résulte une diminution de l'efficacité du blindage magnétique.

### Objet de l'invention

Un objet de l'invention est de réaliser un blindage magnétique dont les performances sont améliorées et maintenues dans le temps.

A cet effet, l'invention concerne un blindage magnétique comportant au moins une paroi latérale définissant une cavité pour contenir un objet à isoler magnétiquement. La paroi latérale comporte au moins une couche de matériau métallique ferromagnétique et au moins une couche de matériau polymère comprenant une poudre ferromagnétique.

Selon un mode de réalisation particulier, l'une au moins des couches métalliques et l'une au moins des couches de polymère ont une interface commune.

De manière préférée, le blindage magnétique peut comporter entre trois et cinq couches métalliques, et entre trois et cinq couches de polymère comprenant une poudre ferromagnétique, deux couches métalliques adjacentes étant séparées par une couche de matériau polymère.

Selon un aspect avantageux de l'invention, le blindage magnétique peut comprendre une couche externe en polymère comprenant une poudre ferromagnétique.

Les matériaux des couches métalliques ferromagnétiques et de la poudre ferromagnétique peuvent être choisis parmi le fer doux, le permalloy, les alliages de fer et/ou nickel et/ou cobalt, et les ferrites. Le matériau polymère peut quant à lui être choisi parmi la résine époxy, les élastomères ou le polyéthylène basse densité.

L'épaisseur de l'une au moins des couches de matériau polymère peut être comprise entre 1 mm et 10 cm.

### Description sommaire des dessins

D'autres avantages et caractéristiques ressortiront plus clairement de la description qui va suivre du mode particulier de réalisation de l'invention donné à titre d'exemple non limitatif et représenté sur le dessin annexé, qui illustre de façon schématique une vue en coupe d'un blindage magnétique cylindrique.

### Description détaillée

Pour isoler magnétiquement un objet d'un environnement extérieur, celui-ci peut être placé dans une cavité dont les parois forment un blindage magnétique. Les parois de la cavité peuvent être réalisées à l'aide d'une couche de métal ferromagnétique usinée pour parvenir à la forme souhaitée (cylindrique, sphérique, parallélépipédique, etc.).

L'usinage fragilise toutefois la structure de la couche métallique ferromagnétique à l'échelle atomique, ce qui limite son efficacité en tant que blindage magnétique. La couche métallique est alors soumise à un ou plusieurs traitements thermiques visant à améliorer la structure cristalline du matériau et à éliminer les impuretés présentes dans le matériau (carbure, sulfure, nitrures) qui pourraient limiter la qualité du blindage.

Durant cette étape de traitement thermique, la couche métallique ferromagnétique est généralement soumise à une température comprise entre 1000 et 1200°C pendant une durée comprise entre 1 et 6h. Ensuite, la température est réduite de manière contrôlée pour éviter la fragilisation du matériau.

Après traitement thermique, la résistance mécanique et thermique de la couche métallique est moindre, et des chocs mécanique ou thermique peuvent altérer la qualité du blindage. Il est donc primordial de manipuler la couche métallique avec précaution et de ne pas la soumettre à de brusques variations de température afin de ne pas altérer son efficacité dans le temps.

Pour améliorer la qualité du blindage magnétique, la cavité peut être réalisée par association de plusieurs couches métalliques ferromagnétiques séparées par des cales ou par des plaques de mousse. Ces éléments exercent cependant des contraintes mécaniques sur les couches métalliques, et altèrent la qualité du blindage.

Par ailleurs dans ce type de dispositif, l'épaisseur des couches métalliques est généralement comprise entre 1 et 3 mm, et l'épaisseur des couches de mousse est de l'ordre de 1 à 5 cm. Un tel dispositif peut donc être encombrant.

L'invention consiste donc à réaliser une cavité 1 ayant des parois résistantes aux chocs thermique et mécanique, et dont l'encombrement est limité par rapport à un dispositif comprenant des couches métalliques et des couches de mousse.

A cet effet, la cavité 1 comporte au moins une couche métallique ferromagnétique 2 entourée par au moins une couche de matériau polymère 3 comprenant une poudre ferromagnétique.

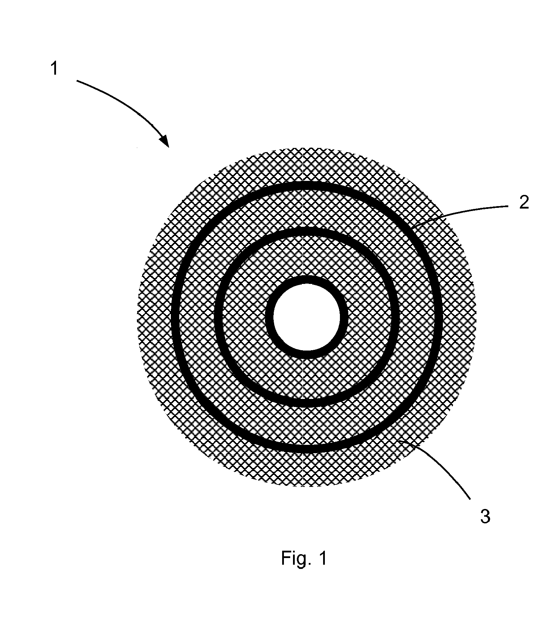

Les couches métalliques ferromagnétiques 2 et les couches polymères 3 comprenant une poudre ferromagnétique peuvent être réalisées sous différentes formes selon la qualité du blindage magnétique souhaitée. Les couches peuvent par exemple être cylindriques comme dans le mode de réalisation de la figure 1, illustrant schématiquement une vue en coupe d'une cavité 1 de forme cylindrique. La cavité 1 peut également être parallélépipédique ou sphérique, ou avoir une forme quelconque si cela est préférable pour que le blindage magnétique soit plus efficace.

L'une au moins des couches métalliques 2 peut être en contact avec l'une au moins des couches de matériau polymère 3, de sorte à limiter les interstices entre les différents éléments composant le dispositif, et donc à augmenter sa compacité. Les couches métalliques 2 et les couches en matériau polymère 3 peuvent donc avoir une interface commune.

Les couches métalliques 2 et les couches de polymère 3 peuvent être disposées en alternance pour que chaque couche polymère 3 serve d'amortisseur thermique et mécanique vis-à-vis des couches métalliques 2 qui sont situées de part et d'autre de la couche polymère 3 considérée.

Pour obtenir un blindage magnétique efficace sans que son coût soit prohibitif, les parois de la cavité 1 peuvent contenir entre trois et cinq couches métalliques ferromagnétiques 2 et entre trois et cinq couches de polymère 3 comprenant chacune une poudre ferromagnétique, deux couches métalliques 2 adjacentes pouvant être séparées par une couche de matériau polymère 3.

Les inventeurs ont en effet constaté que l'efficacité du blindage est notablement améliorée lorsque le dispositif 1 comporte en alternance trois couches métalliques 2 et trois couches de polymère 3 comportant une poudre ferromagnétique, par rapport à un dispositif 1 comportant en alternance deux couches métalliques 2 et deux couches de polymère 3 comportant une poudre ferromagnétique.

Les couches métalliques 2 peuvent être réalisées dans des matériaux identiques ou différents. Par soucis de simplicité de réalisation, le matériau peut être identique pour toutes les couches métalliques 2. Toutefois, il peut être envisagé d'utiliser des matériaux ayant une perméabilité magnétique relative très élevée dans la partie externe du dispositif 1, et d'utiliser des matériaux ayant une perméabilité magnétique relative moindre dans la partie interne. De cette façon, les lignes de champ magnétiques sont déviées d'autant plus efficacement qu'elles se trouvent dans la partie externe du dispositif 1. Les couches métalliques 2 peuvent par exemple être réalisées en fer doux, en permalloy, en ferrite ou en alliage à base de fer et/ou de nickel et/ou de cobalt.

Les couches en matériau polymère 3 ont une épaisseur avantageusement comprise entre 1 mm et 10 cm. Par exemple, dans le cas d'un blindage adapté pour être utilisé en magnéto-cardiographie, les couches en matériau polymère 3 peuvent avoir une épaisseur de 1 à 10 cm. Elles peuvent par exemple être fabriquées à partir de résine époxy, d'élastomère ou de polyéthylène basse densité. De la même façon que pour les couches métalliques 2, les couches en polymère 3 peuvent être réalisées dans des matériaux différents, même si, pour des raisons de simplicité de fabrication, les couches en polymère 3 sont préférablement identiques.

Les matériaux utilisés pour fabriquer les couches en polymère 3 présentent l'avantage d'être peu coûteux et de pouvoir supporter de grandes déformations élastiques avant rupture. Les couches en polymère 3 peuvent donc encaisser des chocs mécaniques sans que leur structure soit dégradée.

L'ajout de poudre ferromagnétique dans la couche en polymère 3 confère des propriétés ferromagnétiques à la couche polymère 3 et contribue donc au blindage magnétique. La poudre ferromagnétique peut être à base de fer, de permalloy, de ferrite ou être un mélange à base de fer et/ou de nickel et/ou de cobalt. Elle peut consister par exemple en une poudre de fer doux, de mumétal (alliage Fe, Ni, Cu, Mo), ou en un métal amorphe.

Selon un mode de réalisation avantageux, la partie la plus externe de la paroi de la cavité 1 peut être formée par une couche en matériau polymère comprenant une poudre ferromagnétique. Cette poudre peut avantageusement avoir une perméabilité magnétique relative élevée et par exemple être du fer doux, de sorte à réduire notablement le champ magnétique au niveau des couches internes de la cavité 1.

Le fait de réaliser une enveloppe externe en matériau polymère sur la partie la plus externe de la paroi de la cavité 1 permet également d'améliorer la résistance du blindage magnétique aux chocs thermiques. La couche en matériau polymère joue alors un rôle d'isolant thermique pour les couches métalliques 2 employées pour réaliser le blindage magnétique.

Le document intitulé « Enhancement of the Relative Magnetic Permeability of Polymeric Composites with Hybrid Particulate Fillers » (Fiske et al., Journal of Applied Polymer Science, 1997) donne la valeur de la perméabilité magnétique relative de plusieurs polymères chargés de poudre ferromagnétique. Par exemple un mélange nommé A, comprenant 35% en volume de polyéthylène basse densité, 50% en volume de ferrite NiZn et 15% en volume de métal amorphe tel que le Metglas® en poudre a une perméabilité magnétique relative de l'ordre de 100. Un mélange nommé B, comportant 90% en volume de polyéthylène basse densité et 10% en volume de métal amorphe tel que le Metglas® en poudre a une perméabilité magnétique relative de l'ordre de 30. A titre de comparaison, la perméabilité magnétique relative du polyéthylène basse densité seul est de l'ordre de 1.

Les mélanges A et B peuvent servir à remplacer les cales ou les mousses placées entre les couches métalliques d'un dispositif de blindage magnétique selon l'art antérieur. Par exemple, pour un blindage cylindrique comprenant en alternance une couche métallique et une couche de polymère chargé de poudre ferromagnétique, 1 mm de mumétal associé à 1 cm de mélange A a une efficacité équivalente à 1 mm de mumétal associé à 3,3 cm de mélange B. Un dispositif selon l'art antérieur ayant une efficacité équivalente correspondrait à une couche métallique de 2 mm de mumétal associée à des cales ou des plaques de mousse de plusieurs centimètres.

L'utilisation d'une couche de polymère chargée de poudre ferromagnétique permet donc d'obtenir un dispositif plus compact car tout le volume occupé par le dispositif joue le rôle de blindage, au contraire des dispositifs comportant des couches de mousse ou des cales, qui sont des éléments ne contribuant pas au blindage magnétique.

Le coût de réalisation de ce dispositif est également moins élevé à efficacité équivalente, car il est plus abordable d'utiliser une poudre ferromagnétique d'une plaque d'un matériau équivalent.

Ce type de blindage est particulièrement adapté pour isoler un objet d'un champ magnétostatique. Pour réaliser un blindage électromagnétique optimal, la poudre ferromagnétique contenue dans la couche en matériaux polymère peut être remplacée par une poudre conductrice de sorte à obtenir une couche polymère électriquement conductrice. Les parois de la cavité 1 pourraient donc être conçues pour réaliser à la fois un blindage magnétostatique et électromagnétique, par exemple en disposant entre les couches métalliques 2 des couches de polymère 3 contenant une poudre ferromagnétique et des couches de polymère contenant des poudres conductrices.

## Revendications

1. Blindage magnétique comportant au moins une paroi latérale définissant une cavité pour contenir un objet à isoler magnétiquement, la paroi latérale comportant entre trois et cinq couches de matériau métallique ferromagnétique, et entre trois et cinq couches de matériau polymère comprenant une poudre ferromagnétique, deux couches métalliques adjacentes étant séparées par une couche de matériau polymère.

2. Blindage magnétique selon la revendication 1, dans lequel l'une au moins des couches métalliques et l'une au moins des couches de polymère ont une interface commune.

3. Blindage magnétique selon l'une quelconque des revendications 1 ou 2, dans lequel la partie externe de la paroi latérale est formée par une couche de matériau polymère.

4. Blindage magnétique selon l'une quelconque des revendications 1 à 3, dans lequel le matériau des couches métalliques est choisi parmi le fer doux, le permalloy, les alliages de fer et/ou nickel et/ou cobalt, et les ferrites.

5. Blindage magnétique selon l'une quelconque des revendications 1 à 4, dans lequel le matériau polymère est choisi parmi les élastomères, la résine époxy, ou le polyéthylène basse densité.

6. Blindage magnétique selon l'une quelconque des revendications 1 à 5, dans lequel la poudre ferromagnétique est choisie parmi le fer doux, le permalloy, les alliages de fer et/ou nickel et/ou cobalt, et les ferrites.

7. Blindage magnétique selon l'une quelconque des revendications 1 à 6, dans lequel l'épaisseur de l'une au moins des couches de matériau polymère est comprise entre 1 mm et 10 cm.
